Europäisches Patentamt

European Patent Office

Office européen des brevets

(11) Publication number: **0 208 547 B1**

## EUROPEAN PATENT SPECIFICATION

(45) Date of publication of patent specification: **10.03.93**

(51) Int. Cl.⁵: **H01P 1/218**, H01F 10/24

(21) Application number: **86305293.2**

(22) Date of filing: **09.07.86**

(54) **YIG thin film microwave apparatus.**

(30) Priority: **09.07.85 JP 150431/85**
**30.04.86 JP 100037/86**

(43) Date of publication of application:
**14.01.87 Bulletin 87/03**

(45) Publication of the grant of the patent:
**10.03.93 Bulletin 93/10**

(84) Designated Contracting States:
**DE FR GB NL**

(56) References cited:
EP-A- 0 057 614
EP-A- 0 208 548
US-A- 4 269 651

**1985 IEEE-MTT-S INTERNATIONAL MICROWAVE SYMPOSIUM DIGEST, Saint Louis, Mis-
souri, 4th-6th June 1985, pages 285-288,
IEEE, New York, US; Y. MURAKAMI et al.: "A
bandpass filter using YIG film grown by LPE"**

(73) Proprietor: **SONY CORPORATION**
**7-35 Kitashinagawa 6-chome Shinagawa-ku
Tokyo 141(JP)**

(72) Inventor: **Murakami, Yoshikazu Patents Divi-
sion**

**Sony Corporation 6-7-35 Kitashinagawa
Shinagawa-ku Tokyo 141(JP)**
Inventor: **Tanaka, Hideo Patents Division**
**Sony Corporation 6-7-35 Kitashinagawa
Shinagawa-ku Tokyo 141(JP)**
Inventor: **Miyake, Masami Patents Division**
**Sony Corporation 6-7-35 Kitashinagawa
Shinagawa-ku Tokyo 141(JP)**
Inventor: **Ito, Seigo Patents Division**
**Sony Corporation 6-7-35 Kitashinagawa
Shinagawa-ku Tokyo 141(JP)**
Inventor: **Tamada, Hitoshi Patent Division**
**Sony Corporation 6-7-35 Kitashinagawa
Shinagawa-ku Tokyo 141(JP)**
Inventor: **Yamada, Toshiro Patent Division**
**Sony Corporation 6-7-35 Kitashinagawa
Shinagawa-ku Tokyo 141(JP)**

(74) Representative: **Pilch, Adam John Michael et
al**
**D. YOUNG & CO. 10 Staple Inn
London WC1V 7RD (GB)**

EP 0 208 547 B1

Rank Xerox (UK) Business Services
(3.10/3.5x/3.0.1)

**Description**

This invention relates to YIG (Yttrium Iron Garnet) thin film microwave apparatus, and in particular to such apparatus including a YIG thin film device utilising the ferrimagnetic resonance effect.

There has been proposed microwave apparatus, such as a microwave filter or a microwave oscillator, utilising the ferrimagnetic resonance of a ferrimagnetic resonator constructed by forming a ferrimagnetic YIG film over a non-magnetic GGG (Gadolinium Gallium Garnet) substrate by means of a liquid-phase epitaxial growth process (hereinafter abbreviated to "LIE process"), and selectively etching the YIG film by a photolithographic process into a desired shape, such as a circular or a rectangular shape. Such microwave apparatus has been proposed in 1985: IEEE-MTT-S INTERNATIONAL MICROWAVE SYMPOSIUM DIGEST, Saint Louis, Missouri, 4-6 June 1985, pages 285-288, IEEE, New York, USA, Y. MURAKAMI et al. " A bandpass filter using YIG film grown by LPE.

Such a microwave device is capable of being used with microstrip lines as transmission lines electromagnetically coupled to the YIG thin film for a microwave integrated circuit, and this facilitates the hybrid connection of one microwave integrated circuit to another microwave integrated circuit. Furthermore, the LPE process and the photolithographic process enable the mass production of microwave devices utilising the magnetic resonance of a YIG film. Microwave devices utilising the magnetic resonance of a YIG film have many practical advantages over conventional microwave devices employing a YIG sphere.

However, since the ferrimagnetic resonance frequency of the YIG film is greatly dependent on temperature, microwave apparatus employing a YIG film has inferior temperature characteristics, which is a significant problem in the practical application of such microwave apparatus.

More specifically, the problem can arise if a YIG film is disposed in a gap of a magnetic circuit so that a DC magnetic field is applied perpendicularly to the film surface thereof and the contribution of an anisotropic field is negligible. Then, the ferrimagnetic resonance frequency of the YIG film can be expressed on the basis of Kittel's formula:

$$f(T) \ = \ \gamma\{Hg(T)-Nz^Y \bullet 4\pi Ms^Y(T)\} \qquad (1)$$

where $\gamma$ is the gyromagnetic ratio ( $\gamma$ = 2.8 MHz/Oe or 35 kHz/A/m), Hg is the DC gap magnetic field, $Nz^Y$ is the demagnetisation factor of the YIG film calculated on the basis of the magnetostatic mode theory, and $4\pi Ms^Y$ is the saturation magnetisation of the YIG film. Since Hg and $4\pi Ms^Y$ are functions of the temperature T, the resonance frequency f is also a function of the temperature T. To take a specific example, in the perpendicular resonance of a YIG disc having an aspect ratio (thickness/diameter) of 0.01, $Nz^Y$ = 0.9774 and if the biasing magnetic field intensity Hg is fixed regardless of temperature, $4\pi Ms^y$ is 1916G (0.1916T) at -20°C and 1622G (0.1622T) at +60°C. Thus, the deviation of the resonance frequency f in this temperature range can be as large as 823 MHz.

Such temperature-dependent deviation of the resonance frequency of a YIG microwave apparatus is avoidable by placing the YIG magnetic resonator in a thermostatic chamber to keep the resonator at a fixed temperature, or by varying the magnetic field intensity by means of an electromagnet according to temperature deviation so that the resonance frequency is maintained at a fixed level. However, these methods require external energy supply and additional control means such as means for controlling electric current, and hence these methods involve complex construction.

According to the present invention there is provided YIG thin film microwave apparatus comprising a YIG thin film device utilising the ferrimagnetic resonance effect, and a magnetic circuit having a gap of length $\ell g$ in which said YIG thin film device is disposed and applying a bias magnetic field perpendicular to a film surface of said YIG thin film device, said magnetic circuit including a permanent magnet having a thickness $\ell m$, characterised by said YIG thin film device being formed of a substituted YIG thin film where part of the $Fe^{3+}$ ions are substituted by an amount $\delta$ of a nonmagnetic element, the amount $\delta$ being expressed as the formula unit, said permanent magnet satisfying the characteristics:

$$Br > (fo/\gamma) \ + \ Nz^Y \ 4\pi Mso^Y(o)$$

$$\alpha_1^B \ > \ \frac{Nz^Y \ 4\pi Mso^Y(o)}{(fo/\gamma) \ + \ Nz^Y \ 4\pi Mso^Y(o)} \bullet \alpha_1^Y(o)$$

$$Br^O = (1 + \frac{\ell g \mu r}{\ell m})(\frac{fo}{\gamma} + Nz^Y \cdot 4\pi Mso^Y(\delta))$$

$$\delta = \frac{-\beta_1 + \sqrt{\beta_1{}^2 - 4\beta_2\left\{1 - \frac{(fo/\gamma)}{\{(\alpha_1{}^Y/\alpha_1{}^B)-1\} Nz^Y \cdot 4\pi Mso^Y(o)}\right\}}}{2\beta_2}$$

wherein:

fo     is the resonance frequency of said YIG thin film device (1);

$\gamma$     is the gyromagnetic ratio of said YIG thin film;

$Nz^Y$     is the demagnetisation factor of said YIG thin film;

$4\pi Mso^Y(0)$     is the saturation magnetisation of said YIG thin film when said amount $\delta$ equals zero at room temperature;

Br     is the remanence of said permanent magnet (4) at room temperature;

$\alpha_1{}^B$     is the first order temperature coefficient of the permanent magnet (4) at or near room temperature;

$\alpha_1{}^Y(0)$     is the first order temperature coefficient of the saturation magnetisation of said YIG thin film when said amount $\delta$ equals zero at or near room temperature;

$Br^o$     is the zero order temperature coefficient of the saturation magnetisation of said YIG thin film;

$\mu r$     is the fixed recoil permeability of said permanent magnet (4);

$4\pi Mso^Y(\delta)$     is the saturation magnetisation of said YIG thin film having the substituted amount $\delta$ ; and

$\beta_1$ and $\beta_2$     are the roots of the approximated equation:

$$4\pi Mso^Y(\delta) = 4\pi Mso^Y(o)(1 + \beta_1\delta + \beta_2\delta^2)$$

A preferred embodiment of the present invention provides a fixed or variable frequency YIG thin film microwave device capable of compensating for the deviation of the temperature characteristics without requiring any external circuit, and thus without involving further power consumption, and which is capable of application to a wide range of working frequencies.

Attention is directed to related European Patent Publication No. EP-A-0 208 548 which concerns a similar type of microwave apparatus, but in that case including soft magnetic plates between the permanent magnets and the gap.

The invention will now be described by way of example with reference to the accompanying drawings, throughout which like parts are referred to by like references, and in which:

Figure 1 is a diagrammatic view showing the constitution of a YIG film microwave device according to a preferred embodiment of the invention; and

Figure 2 is a graph showing the deviation of the saturation magnetisation ($4\pi Ms^Y$) of the YIG film with temperature (T) for substitution rates ($\delta$).

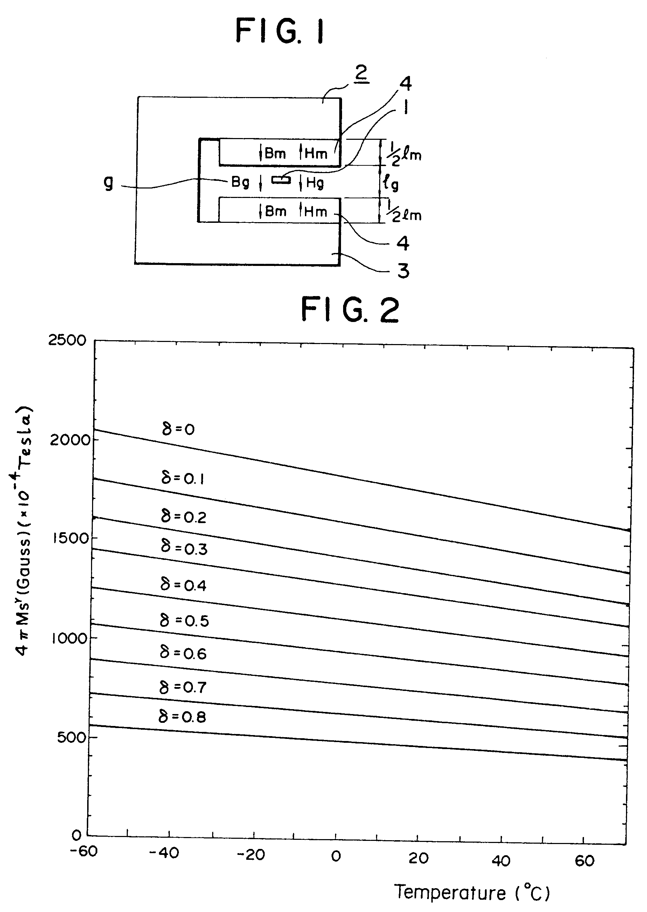

Referring to Figure 1, YIG film microwave apparatus comprises a YIG film microwave element or device 1 and a magnetic circuit 2 for applying a biasing magnetic field to the YIG microwave device 1. The magnetic circuit 2 comprises, for example, a U-shaped yoke 3 and a pair of permanent magnets 4 each having a thickness of $\ell m/2$ and attached to the inner surfaces of the opposite legs of the yoke 3, respectively, with a gap g having a gap width of $\ell g$ therebetween. The YIG film microwave device 1 is disposed in the gap g. The remanence Br of the permanent magnets 4 at room temperature is not less than $(fo/\gamma) + Nz^Y \cdot 4\pi Mso^Y(0)$ and the first order temperature coefficient of rem anence Br at room temperature is not less than

$$\alpha_1{}^Y(0).Nz^Y.4\pi Mso^Y(0)/\{(fo/\gamma) + Nz^Y.4 Mso^Y(0)\},$$

where fo is the working frequency, $Nz^Y$ is the demagnetisation factor of the YIG film, $\gamma$ is the gyromagnetic

ratio, $4\pi Mso^Y(0)$ is the saturation magnetisation at room temperature when the substitution rate of the nonmagnetic ions of the YIG film for $Fe^{3+}$ is zero, and $\alpha_1^Y(0)$ is the first order temperature coefficient of the saturation magnetisation of the YIG film when the same substitution rate is zero. The working frequency fo is fixed in this arrangement when the working frequency of the YIG film microwave device is to be fixed and, when the working frequency of the YIG film microwave device is to be variable, the working frequency can be varied by superposing a variable biasing magnetic field which can, for example, be produced by controlling the excitation current of a solenoid (not shown) over the fixed biasing magnetic field, such that the value of the working frequency fo is a particular frequency when the excitation current is zero.

The temperature-dependent variation of the resonance frequency is compensated for by using a substituted YIG produced by partially substituting the $Fe^{3+}$ ions of the YIG film by nonmagnetic ions, namely, trivalent nonmagnetic ions, such as $Ga^{3+}$ ions or $A\ell^{3+}$ ions, or a combination of divalent ions, such as $Ca^{2+}$ ions, and tetravalent ions, such as $Ge^{4+}$, which combination is equivalent to trivalent ions.

In the magnetic circuit shown in Figure 1, suppose that all the magnetic flux passes across the gap g, the magnetic flux density of the gap g is uniform and the magnetic permeability of the yoke is infinity. Then, from Maxwell's equations,

$$Bm = Bg \qquad (2)$$

$$\ell mHm = \ell gHg \qquad (3)$$

where Bm and Bg are the magnetic flux densities in the permanent magnets 4 and the magnetic gap, respectively, and Hm and Hg are the magnetic fields in the permanent magnets 4 and the magnetic gap g, respectively. The direction of Hm is opposite to those of Hg, Bm and Bg.

Suppose that the permanent magnets 4 do not have knee points and have a linear demagnetisation curve of a fixed recoil permeability $\mu r$. Then,

$$Hm = \tfrac{1}{\mu r}(Br-Bm) = \tfrac{1}{\mu r}(Br-Hg) \qquad (4)$$

Combining Equations (3) and (4), the magnetic field Hg in the magnetic gap g of the magnetic circuit 2 is expressed as a function of the temperature T by

$$Hg(T) = \frac{\ell mBr(T)/\mu r}{(\ell m/\mu r)+\ell g} \qquad \cdots\cdots\cdots\cdots\cdots\cdots\cdots (5)$$

From Equations (1) and (5), the following equation must hold in order that the resonance frequency is fixed at a fixed value fo regardless of the temperature T.

$$\frac{\ell mBr(T)/\mu r}{(\ell m/\mu r)+\ell g} = (fo/\gamma)+Nz^Y\cdot 4\pi Ms^Y(T) \qquad \cdots\cdots\cdots\cdots\cdots (6)$$

On the other hand, the remanence Br of the permanent magnets 4 and the saturation magnetisation $4\pi Ms^Y$ of the YIG film microwave element 1 can be sufficiently correctly expressed by taking the first order temperature coefficient $\alpha_1^B$ and the second order temperature coefficient $\alpha_2^B$ into consideration in the temperature range of room temperature plus and minus tens of degrees. Therefore,

$$Br(T) = Br^o\{1+\alpha_1^B(T-To)+\alpha_2^B(T-To)^2\} \qquad (7)$$

$$4\pi Ms^Y(T) = 4\pi Mso^Y\{1+\alpha_1^Y(T-To)+\alpha_2^Y(T-To)^2\} \qquad (8)$$

Substituting Equations (7) and (8) into Equation (6) and supposing that the terms of zero, first and second order with respect to temperature T on both sides are equal to each other,

4

$$Br^{o} = (1+\frac{\ell g \mu r}{\ell m})(\frac{fo}{\gamma} + Nz^{Y} \cdot 4\pi Mso^{Y}) \quad \dots\dots\dots\dots \quad (9)$$

$$\alpha_1^{B} = \frac{Nz^{Y} \cdot 4\pi Mso^{Y}}{(fo/\gamma)+Nz^{Y} \cdot 4\pi Mso^{Y}} \cdot \alpha_1^{Y} \quad \dots\dots\dots\dots (10)$$

$$\alpha_2^{B} = \frac{Nz^{Y} \cdot 4\pi Mso^{Y}}{(fo/\gamma)+Nz^{Y} \cdot 4\pi Mso^{Y}} \cdot \alpha_2^{Y} \quad \dots\dots\dots\dots (11)$$

It is seen from Equation (9) that the permanent magnets 4 need to satisfy an inequality: $Br^{0} > (fo/\gamma) + Nz^{Y}.4\pi so^{Y}$. It is also seen from Equations (10) and (11) that the optimum values of the first and second order temperature coefficients of Br are dependent only on the resonance frequency, the demagnetisation factor of the YIG film, and the saturation magnetisation and temperature coefficient of the YIG film. For example, in the perpendicular resonance of a YIG disc of 0.01 in aspect ratio (thickness/diameter), $Nz^{Y} = 0.9774$, and, at To = 20°C, $4\pi Mso^{Y} = 1771.8$ G (0.17718T), $\alpha_1^{Y} = -2.07 \times 10^{-3}$, and $\alpha_2^{Y} = -0.996 \times 10^{-6}$. The first and second order temperature coefficients of Br calculated by using those values are tabulated in Table 1. However, practically, it is scarcely possible to prepare a permanent magnet capable of simultaneously satisfying both Equations (10) and (11). Therefore, only the conditions of Equation (10) for making the gradient of the temperature characteristics curve of the YIG film microwave device zero will be discussed herein. Since the value of $\alpha_1^{B}$ is inherent in the factor of the permanent magnet employed, a resonance frequency that meets Equation (10) is determined uniquely. For example, resonance frequencies that make the gradient of the temperature characteristics curve zero for microwave devices having permanent magnets of $Nd_2Fe_{14}B$ having $\alpha_1^{B} = -1.12 \times 10^{-3}$, permanent magnets of $CeCo_5$ having $\alpha_1^{B} = -0.9 \times 10^{-3}$ and permanent magents of $SmCo_5$ having $\alpha_1^{B} = -0.5 \times 10^{-3}$ are 4.11 GHz, 6.30 GHz and 15.2 GHz, respectively. Thus, when such existing permanent magnets are employed, the working frequency which will realise satisfactory temperature characteristics of the YIG film is restricted. The substitution rate $\delta$ of non-magnetic ions for substituting the $Fe^{3+}$ ions of the YIG film is controlled to achieve satisfactory temperature characteristics of the YIG film microwave device employing the existing permanent magnets for a wide range of working frequencies.

| $f_o$ (GHz) | $\alpha_1{}^B$ | $\alpha_2{}^B$ |
|---|---|---|
| 1.0 | $-1.72 \times 10^{-3}$ | $-8.26 \times 10^{-7}$ |
| 2.0 | $-1.47 \times 10^{-3}$ | $-7.05 \times 10^{-7}$ |
| 3.0 | $-1.28 \times 10^{-3}$ | $-6.15 \times 10^{-7}$ |
| 4.0 | $-1.14 \times 10^{-3}$ | $-5.46 \times 10^{-7}$ |
| 5.0 | $-1.02 \times 10^{-3}$ | $-4.90 \times 10^{-7}$ |
| 6.0 | $-9.26 \times 10^{-4}$ | $-4.45 \times 10^{-7}$ |
| 7.0 | $-8.48 \times 10^{-4}$ | $-4.08 \times 10^{-7}$ |
| 8.0 | $-7.82 \times 10^{-4}$ | $-3.76 \times 10^{-7}$ |
| 9.0 | $-7.25 \times 10^{-4}$ | $-3.49 \times 10^{-7}$ |
| 10.0 | $-6.76 \times 10^{-4}$ | $-3.25 \times 10^{-7}$ |
| 11.0 | $-6.34 \times 10^{-4}$ | $-3.05 \times 10^{-7}$ |
| 12.0 | $-5.96 \times 10^{-4}$ | $-2.87 \times 10^{-7}$ |
| 13.0 | $-5.63 \times 10^{-4}$ | $-2.71 \times 10^{-7}$ |
| 14.0 | $-5.33 \times 10^{-4}$ | $-2.56 \times 10^{-7}$ |
| 15.0 | $-5.06 \times 10^{-4}$ | $-2.43 \times 10^{-7}$ |
| 16.0 | $-4.82 \times 10^{-4}$ | $-2.32 \times 10^{-7}$ |
| 17.0 | $-4.60 \times 10^{-4}$ | $-2.21 \times 10^{-7}$ |
| 18.0 | $-4.40 \times 10^{-4}$ | $-2.11 \times 10^{-7}$ |
| 19.0 | $-4.21 \times 10^{-4}$ | $-2.03 \times 10^{-7}$ |
| 20.0 | $-4.04 \times 10^{-4}$ | $-1.94 \times 10^{-7}$ |

Table I.   Calculated temperature coefficients $\alpha_1{}^B$ and $\alpha_2{}^B$ for frequencies $f_o$.

The deviation of the saturation magnetisation of the YIG film resulting from the substitution of $Fe^{3+}$ ions of the YIG film by nonmagnetic ions will be described hereinafter. Among five $Fe^{3+}$ ions of a pure single crystal of $Y_3Fe_5O_{12}$, three $Fe^{3+}$ ions are at the tetrahedral site and two $Fe^{3+}$ ions are at the octahedral site. The $Fe^{3+}$ ions at the tetrahedral site and those at the octahedral site are arranged in an antiparallel arrangement due to strong superchange interaction. Accordingly, the magnetic moment of five Bohr

magnetons ($5\ \mu_B$) of one $Fe^{3+}$ ion contributes to the saturation magnetisation of the YIG film. Suppose that some of the $Fe^{3+}$ ions of the YIG film were substituted by nonmagnetic $Ga^{3+}$ ions. Since all the $Fe^{3+}$ ions substituted by $Ga^{3+}$ ions are those at the tetrahedral site when the substitution rate is not very large, the magnetic moment of one molecule of $Y_3Fe_5O_{12}$ is $5\mu_B \times \{(3-\delta)-2\} = 5(1-\delta)\mu_B$, and the saturation magnetisation is reduced thereby. The details of the saturation magnetisation of Ga-substituted YIG is described in Journal of Applied Physics, Vol. 45, No. 6, pp. 2725 to 2732, June, 1974. The variation of the saturation magnetisation of $Y_3Fe_5-\delta Ga\delta O_{12}$ with temperature for Ga-substitution rates was calculated by using Expressions (1) to (4) of the above-mentioned paper. The calculated results are shown in Figure 2. Saturation magnetisation $4\pi Ms^Y$ at 20°C, and the first and second order temperature coefficients $\alpha_1^Y$ and $\alpha_2^Y$ in the temperature range of -20°C to +60°C, for Ga-substitution rate $\delta$ are tabulated in Table II. It is seen from Table II that the saturation magnetisation of YIG at room temperature decreases monotonously as the substitution rate $\delta$ increases, while the first order temperature coefficient $\alpha_1^Y$ of saturation magnetisation remains practically constant independently of the variation of the substitution rate $\delta$.

| $\delta$ | $4\pi M_s^Y$ (Gauss) | $\alpha_1^Y$ | $\alpha_2^Y$ |
|---|---|---|---|
| 0 | 1771.8 | $-2.07 \times 10^{-3}$ | $-9.96 \times 10^{-7}$ |
| 0.1 | 1590.4 | $-2.12 \times 10^{-3}$ | $-1.22 \times 10^{-6}$ |
| 0.2 | 1413.9 | $-2.18 \times 10^{-3}$ | $-1.50 \times 10^{-6}$ |
| 0.3 | 1242.8 | $-2.23 \times 10^{-3}$ | $-1.84 \times 10^{-6}$ |
| 0.4 | 1077.6 | $-2.28 \times 10^{-3}$ | $-2.26 \times 10^{-6}$ |
| 0.5 | 918.9 | $-2.33 \times 10^{-3}$ | $-2.81 \times 10^{-6}$ |
| 0.6 | 767.2 | $-2.36 \times 10^{-3}$ | $-3.53 \times 10^{-6}$ |
| 0.7 | 623.0 | $-2.37 \times 10^{-3}$ | $-4.41 \times 10^{-6}$ |
| 0.8 | 487.0 | $-2.33 \times 10^{-3}$ | $-5.92 \times 10^{-6}$ |

Table II Saturation, magnetisation and temperature coefficient for Ga-substitution rate ($\delta$)

On the other hand, conditional Equations (9) and (10) for the permanent magnet can be rewritten by expressing the saturation magnetisation of YIG and the first order temperature coefficient of the saturation magnetisation as functions of the substitution rate $\delta$, respectively,

$$Br^o = (1 + \frac{\ell g \mu r}{\ell m})(\frac{fo}{\gamma} + Nz^Y \cdot 4\pi Mso^Y(\delta)) \qquad \cdots\cdots\cdots\cdots (9')$$

$$\alpha_1^B = \frac{Nz^Y \cdot 4\pi Mso^Y(\delta)}{(fo/\gamma) + Nz^Y \cdot 4\pi Mso^Y(\delta)} \cdot \alpha_1^Y(\delta) \qquad \cdots\cdots\cdots\cdots (10')$$

Since $4\pi Ms^Y(\delta)$ decreases monotonously as the substitution rate increases, if an inequality

$$Br^o > \frac{fo}{\gamma} + Nz^Y \cdot 4\pi Mso^Y(o) \qquad (12)$$

is satisfied, a solution of the thickness $\ell m$ of the permanent magnet meeting Equation (9') independently of substitution rate $\delta$ can be found. In Equation (10'), both $\alpha_1^B$ and $\alpha_1^Y(\delta)$ are negative values and, as mentioned above, $\alpha_1^Y$ remains practically constant regardless of the value of the substitution rate, while $4\pi Mso^Y(\delta)$ decreases monotonously as $\delta$ increases. Accordingly, the coefficient for $\alpha_1^Y(\delta)$ in equation (10'), $Nz^Y \cdot 4\pi Mso^Y(\delta)/\{(fo/\gamma) + Nz^Y \cdot 4\pi Mso^Y(\delta)\}$ is always positive and decreases monotonously as the substitution rate $\delta$ increases. Accordingly, if the condition

$$\alpha_1^B > \frac{Nz^Y \cdot 4\pi Mso^Y(o)}{(fo/\gamma) + Nz^Y \cdot 4\pi Mso^Y(o)} \cdot \alpha_1^Y(o) \qquad \cdots\cdots\cdots\cdots (13)$$

is established, Equation (10') can be satisfied by properly determining the substitution rate $\delta$. That is, desired temperature characteristics can be obtained by properly regulating the substitution rate of $Fe^{3+}$ ions by nonmagnetic ions.

Since the analytical determination of the value of $\delta$ that satisfied Equation (10') is impossible, the same value is determined through computer simulation. However, supposing that the dependence of $\alpha_1^Y(\delta)$ on $\delta$ is insignificant and that $4\pi Mso^Y(\delta)$ is approximated by a quadratic equation

$$4\pi Mso^Y(\delta) = 4\pi Mso^Y(o)(1 + \beta_1\delta + \beta_2\delta^2) \qquad (14)$$

the approximate optimum value of the substitution rate $\delta$ can be obtained through calculation by using

$$\delta = \frac{-\beta_1 + \sqrt{\beta_1^2 - 4\beta_2\left\{1 - \frac{(fo/\gamma)}{\{(\alpha_1^Y/\alpha_1^B) - 1\}Nz^Y \cdot 4\pi Mso^Y(o)}\right\}}}{2\beta_2}$$

$$\cdots\cdots\cdots\cdots (15)$$

| Nd$_2$Fe$_{14}$B | | | | |
|---|---|---|---|---|
| f (GHz) | δ | ℓm (mm) | Δf (MHz) | Temperature chara-cteristics curve |
| 1.0 | 0.90 | 0.23 | 9.4 | Upward concave |
| 2.0 | 0.68 | 0.48 | 7.9 | " |
| 3.0 | 0.42 | 0.80 | 3.8 | " |
| 4.0 | 0.05 | 1.34 | 1.9 | Upward convex |

| CeCo$_5$ | | | | |
|---|---|---|---|---|
| f (GHz) | δ | ℓm (mm) | Δf (MHz) | Temperature chara-cteristics curve |
| 1.0 | 0.98 | 0.34 | 10.2 | Upward concave |
| 2.0 | 0.82 | 0.73 | 12.5 | " |
| 3.0 | 0.67 | 1.23 | 12.3 | " |
| 4.0 | 0.50 | 1.92 | 11.2 | " |
| 5.0 | 0.31 | 3.01 | 10.0 | " |
| 6.0 | 0.08 | 5.01 | 8.5 | " |

| SmCo$_5$ | | | | |
|---|---|---|---|---|
| f (GHz) | δ | ℓm (mm) | Δf (MHz) | Temperature chara-cteristics curve |
| 3.0 | 0.93 | 0.59 | 11.3 | Upward concave |
| 4.0 | 0.86 | 0.83 | 12.2 | " |
| 5.0 | 0.79 | 1.11 | 12.5 | " |
| 6.0 | 0.72 | 1.43 | 12.5 | " |
| 7.0 | 0.66 | 1.80 | 12.3 | " |
| 8.0 | 0.59 | 2.26 | 11.9 | " |
| 9.0 | 0.52 | 2.81 | 11.4 | " |
| 10.0 | 0.44 | 3.51 | 10.8 | " |
| 11.0 | 0.36 | 4.41 | 10.3 | " |
| 12.0 | 0.28 | 5.64 | 9.9 | " |
| 13.0 | 0.20 | 7.40 | 9.4 | " |
| 14.0 | 0.11 | 10.10 | 8.8 | " |
| 15.0 | 0.02 | 14.72 | 7.9 | " |

Table III    Optimum substitution rate ($\delta$), thickness ($\ell$m) of the permanent

magnet and frequency variation ($\Delta$f) for frequencies f.

EXAMPLES

YIG film microwave apparatus of the constitution shown in Figure 1, having a magnetic gap g of 3 mm and employing Nd$_3$Fe$_{14}$B permanent magnets, CeCo$_5$ permanent magnets and SmCo$_5$ permanent magnets as the permanent magnets 4, were respectively fabricated. The results of simulation using Equation (15) for

EP 0 208 547 B1

various working frequencies f of the YIG film microwave devices are tabulated in Tables IIIA, IIIB and IIIC, in which the values of & are optimum substitution rates to make the gradients of the temperature chracteristics curves of the YIG film microwave devices zero, the values of $\ell$m are the respective necessary total thicknesses of the permanent magnets 4, and the values of $\Delta$f are frequency deviations in the temperature range of -20°C to +60°C estimated by taking the second order temperature coefficient into consideration. As is apparent from Tables IIIA, IIIB and IIIC, the regulation of the substitution rate $\delta$ of the $Fe^{3+}$ ions of the YIG film by nonmagnetic ions provides YIG film microwave apparatus employing existing permanent magnets with satisfactory temperature characteristics over a wide range of working frequencies.

Although the embodiments of the invention have been described as being applied to a fixed frequency YIG film microwave device, the present invention is also applicable to variable frequency YIG film microwave devices having a coil (not shown) wound on the yoke 3 of the magnetic circuit 2.

As will be apparent from what has been described hereinbefore, microwave devices having satisfactory temperature characteristics can be obtained, and the utility of the microwave devices is enhanced by the possibility of mass-producing YIG films, which brings about significant industrial advantages.

**Claims**

1.  YIG thin film microwave apparatus comprising a YIG thin film device (1) utilising the ferrimagnetic resonance effect, and a magnetic circuit (2) having a gap of length $\ell$g in which said YIG thin film device (1) is disposed and applying a bias magnetic field perpendicular to a film surface of said YIG thin film device (1), said magnetic circuit (2) including a permanent magnet (4) having a thickness $\ell$m, characterised by said YIG thin film device (1) being formed of a substituted YIG thin film where part of the $Fe^{3+}$ ions are substituted by an amount $\delta$ of a nonmagnetic element, the amount $\delta$ being expressed as the formula unit, said permanent magnet (4) satisfying the characteristics:

$$Br > (fo/\gamma) + Nz^Y \, 4\pi Mso^Y \, (o)$$

$$\alpha_1^B > \frac{Nz^Y \, 4\pi Mso^Y (o)}{(fo/\gamma) + Nz^Y \, 4\pi Mso^Y (o)} \cdot \alpha_1^Y (o)$$

$$Br^O = (1 + \frac{\ell g \mu r}{\ell m}) (\frac{fo}{\gamma} + Nz^Y \cdot 4\pi Mso^Y (\delta))$$

$$\delta = \frac{-\beta_1 + \sqrt{\beta_1^2 - 4\beta_2 \left\{ 1 - \frac{(fo/\gamma)}{\{(\alpha_1^Y / \alpha_1^B) - 1\} Nz^Y \cdot 4\pi Mso^Y (o)} \right\}}}{2\beta_2}$$

wherein:

| | |
|---|---|
| fo | is the resonance frequency of said YIG thin film device (1); |
| $\gamma$ | is the gyromagnetic ratio of said YIG thin film; |
| $Nz^Y$ | is the demagnetisation factor of said YIG thin film; |
| $4\pi Mso^Y(0)$ | is the saturation magnetisation of said YIG thin film when said amount $\delta$ equals zero at room temperature; |
| Br | is the remanence of said permanent magnet (4) at room temperature; |
| $\alpha_1^B$ | is the first order temperature coefficient of the permanent magnet (4) at or near room temperature; |
| $\alpha_1^Y(0)$ | is the first order temperature coefficient of the saturation magnetisation of said YIG |

thin film when said amount $\delta$ equals zero at or near room temperature;

Br°      is the zero order temperature coefficient of the saturation magnetisation of said YIG thin film;

$\mu r$      is the fixed recoil permeability of said permanent magnet (4);

$4\pi Mso^Y(\delta)$      is the saturation magnetisation of said YIG thin film having the substituted amount $\delta$; and

$\beta_1$ and $\beta_2$      are the roots of the approximated equation:

$$4\pi Mso^Y(\delta) \ = \ 4\pi Mso^Y(O) \ (1 + \beta_1\delta + \beta_2\delta^2)$$

## Patentansprüche

1. Mikrowellenvorrichtung mit einer YIG(Yttrium-Eisen-Granat)-Dünnschicht, bestehend aus einer YIG-Dünnschichteinrichtung (1), welche den ferrimagnetischen Resonanzeffekt ausnutzt, und einem magnetischen Kreis (2), welcher einen Spalt von der Länge 1g aufweist, in dem die genannte YIG-Dünnschichteinrichtung (1) angeordnet ist, und der ein Vormagnetisierungsfeld senkrecht zu einer Schichtoberfläche an die genannte YIG-Dünnschichteinrichtung (1) anlegt, wobei der magnetische Kreis (2) einen Permanentmagneten (4) mit einer Dicke 1m enthält, dadurch gekennzeichnet, daß die genannte YIG-Dünnschichteinrichtung (1) aus einer ersetzten YIG-Dünnschicht gebildet ist, bei der ein Teil der $Fe^{3+}$-Ionen durch eine Menge $\delta$ eines nichtmagnetischen Elements ersetzt sind, wobei die Menge $\delta$ als Formel dargestellt ist und der genannte Permanentmagnet (4) folgenden Angaben genügt:

$$Br > (fo/\gamma) + Nz^Y \cdot 4\pi Mso^Y (o)$$

$$\alpha_1^B > \frac{Nz^Y \ 4\pi Mso^Y (o)}{(fo/\gamma) + Nz^Y \ 4\pi Mso^Y} \cdot \alpha_1^Y (o)$$

$$Br^O = (1 + \frac{1g\mu r}{1m})(\frac{fo}{\gamma} + Nz^Y 4\pi Mso^Y (\delta))$$

$$\delta = \frac{-\beta_1 + \sqrt{\beta_1^2 - 4\beta_2 \left\{ 1 - \frac{(fo/\gamma)}{((\alpha_1^Y/\alpha_1^B) - 1) Nz^Y \ 4\pi Mso^Y(o)} \right\}}}{2\beta_2}$$

worin:

fo      die Resonanzfrequenz der genanntenn YIG-Dünnschichteinrichtung (1) ist,

$\gamma$      das gyromagnetische Verhältnis der genannten YIG-Dünnschicht ist,

$Nz^Y$      der Entmagnetisierungsfaktor der genannten YIG-Dünnschicht ist,

$4\pi Mso^Y(0)$      die Sättigungsmagnetisierung der genannten YIG-Dünnschicht ist, wenn der Wert $\delta$ bei Raumtemperatur gleich Null ist,

Br      die Remanenz des genannten Dauermagneten (4) bei Raumtemperatur ist,

$\alpha_1^B$      der Temperaturkoeffizient erster Ordnung des Dauermagneten (4) bei oder nahe der Raumtemperatur ist,

$\alpha_1^Y(o)$      der Temperaturkoeffizient erster Ordnung der Sättigungsmagnetisierung der genannten YIG-Dünnschicht ist, wenn der Wert $\delta$ bei oder nahe der Raumtemperatur gleich Null ist,

Br°      der Temperaturkoeffizient nullter Ordnung der Sättigungsmagnetisierung der genannten YIG-Dünnschicht ist,

$\mu r$      die feste reversible Permeabilität des genannten Dauermagnetes (4) ist,

$4\pi Mso^Y(\delta)$ die Sättigungsmagnetisierung der genannten YIG-Dünnschicht mit dem ersetzten Wert $\delta$, und

$\beta_1$ und $\beta_2$ die Wurzeln der angenäherten Gleichung

$$4\ Mso^Y(\delta)\ =\ 4\ Mso^Y\ (O)\ (1 + \beta_1\delta + \beta_2\delta^2)$$

sind.

## Revendications

1. Appareil hyperfréquence à pellicule mince de YIG, comprenant un dispositif (1) à pellicule mince de YIG utilisant l'effet de résonance ferrimagnétique, et un circuit magnétique (2) possédant un entrefer de longueur $\ell g$ dans lequel ledit dispositif (1) à pellicule mince de YIG est placé et appliquant un champ magnétique de polarisation perpendiculaire à une surface de pellicule dudit dispositif (1) à pellicule mince de YIG, ledit circuit magnétique (2) comportant un aimant permanent (4) qui possède une épaisseur $\ell m$, caractérisé en ce que ledit dispositif (1) à pellicule mince de YIG est formé d'une pellicule mince de YIG substitué où une partie des ions $Fe^{3+}$ sont remplacés par une quantité $\delta$ d'un élément non magnétique, la quantité $\delta$ étant exprimée comme une unité de formule, ledit aimant permanent (4) satisfaisant les caractéristiques :

$$Br > (fo/\gamma) + Nz^Y\ 4\pi Mso^Y\ (0)$$

$$\alpha_1^{\ B} > \frac{Nz^Y\ 4\pi Mso^Y(0)}{(fo/\gamma) + Nz^Y\ 4\pi Mso^Y(0)}\ \cdot\ \alpha_1^{\ Y}(0)$$

$$Br^O = (1 + \frac{\ell g \mu r}{\ell m})(\frac{fo}{\gamma} + Nz^Y \cdot 4\pi Mso^Y(\delta))$$

$$\delta = \frac{-\beta_1 + \sqrt{\beta_1^{\ 2} - 4\beta_2\left\{1 - \frac{(fo/\gamma)}{\{(\alpha_1^{\ Y}/\alpha_1^{\ B}) - 1\}\ Nz^Y \cdot 4\pi Mso^Y(0)}\right\}}}{2\beta_2}$$

où :

fo est la fréquence de résonance dudit dispositif (1) à pellicule mince de YIG;

$\gamma$ est le rapport gyromagnétique de ladite pellicule mince de YIG;

$Nz^Y$ est le coefficient de désaimantation de ladite pellicule mince de YIG;

$4\pi Mso^Y(0)$ est l'aimantation à saturation de ladite pellicule mince de YIG lorsque ladite quantité $\delta$ vaut zéro à la température ambiante;

Br est la rémanence dudit aimant permanent (4) à la température ambiante;

$\alpha_1^{\ B}$ est le coefficient de température au premier ordre de l'aimant permanent (4) à la température ambiante ou en son voisinage;

$\alpha_1^{\ Y}(0)$ est le coefficient de température au premier ordre de l'aimantation à saturation de ladite pellicule mince de YIG lorsque la quantité $\delta$ vaut zéro à la température ambiante ou en son voisinage;

$Br^o$ est le coefficient de température d'ordre zéro de l'aimantation à saturation de ladite pellicule mince de YIG;

$\mu r$ est la perméabilité de recul fixe dudit aimant permanent (4);

$4\pi Mso^Y(\delta)$ est l'aimantation à saturation de ladite pellicule mince de YIG ayant la quantité substituée $\delta$ et

$\beta_1$ et $\beta_2$ sont les racines de l'équation approchée:

$$4\pi Mso^Y(\delta) = 4\pi Mso^Y(O)(1 + \beta_1\delta + \beta_2\delta^2)$$

# FIG. I

# FIG. 2